# EUROPEAN PATENT APPLICATION

(11) **EP 4 456 371 A1**
(43) Date of publication of application: **30.10.2024**
(21) Application number: 23201100.7
(22) Date of filing: 30.09.2023
(51) Int. Cl.: H02J 7/00, H01M 10/42, H01M 10/44

(54) **ENERGY-SAVING TESTING SYSTEM FOR MICROGRID DC BUS IN BACK SECTION OF BATTERY CELL PRODUCTION**

(30) Priority: 28.04.2023 CN 202310489988
(71) Applicant: GUANGDONG HYNN TECHNOLOGY CO:, LTD, Dongguan, Guangdong (CN)
(72) Inventor: Xie, Di, Dongguan (CN); Wang, Liangliang, Dongguan (CN); Yao, Jigang, Dongguan (CN); Wang, Shoumo, Dongguan (CN); Luo, Jianle, Dongguan (CN); Mo, Linzhen, Dongguan (CN); Zhou, Haiyang, Dongguan (CN); Wu, Hui, Dongguan (CN)
(74) Representative: Meyer, Thorsten

(57) **Abstract**

An energy-saving testing system for a microgrid DC bus in a back section of a battery cell production is provided. The system includes a DC bus subsystem and a testing subsystem for the battery cell production in the back section. The DC bus subsystem includes a DC bus configured to provide a DC power to the testing subsystem; the testing subsystem includes multiple formation cabinets and multiple capacity-grading cabinets, each formation cabinet or each capacity-grading cabinet includes a corresponding DC/DC power supply and a battery cell, and the multiple formation cabinets and multiple capacity-grading cabinets are connected to the DC bus. The energy wastage issues in the existing technology are solved.

## Description

### FIELD OF THE INVENTION

The present invention relates to the technical field of production and testing of battery cells and modules, in particular to an energy-saving testing system for a microgrid DC (direct current) bus in a back section of a battery cell production.

### BACKGROUND OF THE INVENTION

With the increasing popularity of energy storage technology in various fields and the integration of the 2025 plan for electric vehicles and the "Carbon Neutrality and Peak Carbon Emissions" development guidance for the energy storage industry, various energy storage products such as lithium-ion power batteries are entering a period of rapid development. The power density and the application market are increasing exponentially, resulting in increased energy consumption during the production process of these products. Therefore, the research and development of key technologies such as intelligent energy saving and carbon reduction in this field are particularly important.

Existing production testing systems for the formation and capacity-grading in the back section of battery cell production have many shortcomings. For example, the formation and capacity-grading cabinets often use a distributed AC/DC power supply combined with a DC/DC power supply, resulting in high energy consumption and significant energy losses between battery cells. The application scenarios for energy-saving and intelligent systems are limited, and the actual energy-saving effects are not significant. Air cooling is mainly used, which dissipates heat into the air, resulting in additional energy consumption for the ventilation system. The energy consumption and temperature control of multiple modules in the system are not centrally and intelligently controlled, and the system functions are too independent, resulting in unnecessary waste. The safety protection measures of the equipment are inadequate, which leads to safety hazards in the event of system failures. The system uses traditional power supply methods and is not connected to a multi-energy complementary control system to reduce carbon emissions. Therefore, there are energy wastage issues in the existing technology.

### SUMMARY OF THE INVENTION

The present invention provides an energy-saving testing system for a microgrid DC bus in a back section of a battery cell production, which at least solves the energy wastage issues in the existing technology.

According to an aspect of the embodiments of the present invention, an energy-saving testing system for a microgrid DC bus in a back section of a battery cell production is provided. The system includes a DC bus subsystem and a testing subsystem for the battery cell production in the back section. The DC bus subsystem includes a DC bus configured to provide a DC power to the testing subsystem; the testing subsystem includes multiple formation cabinets and multiple capacity-grading cabinets, each formation cabinet or each capacity-grading cabinet includes a corresponding DC/DC power supply and a battery cell, and the multiple formation cabinets and multiple capacity-grading cabinets are connected to the DC bus.

Optionally, the DC bus subsystem further includes multiple AC (alternate current) distribution cabinets, multiple energy storage inverters, a first DC distribution cabinet, a first DC power switch, and a second DC power switch. Each AC distribution cabinet is connected to a corresponding energy storage inverter, and the multiple energy storage inverters are connected to one end of the first DC distribution cabinet, another end of the first DC distribution cabinet is connected to the DC bus; one end of the first DC power switch is connected to the DC bus, and another end of the first DC power switch is connected to the multiple formation cabinets; one end of the second DC power switch is connected to the DC bus, and another end of the second DC power switch is connected to the multiple capacity-grading cabinets. Each AC distribution cabinet is configured to deliver a grid AC power to the corresponding energy storage inverter, which converts the grid AC power into the DC power; the first DC distribution cabinet is configured to combine DC powers from multiple energy storage inverters and deliver to the DC bus; and the first DC power switch and the second DC power switch are configured to control a connection or a disconnection of the multiple formation cabinets and multiple capacity-grading cabinets to the DC bus.

Optionally, the system further includes a new energy subsystem connected to the DC bus and configured to convert various new energy sources into the DC power and then connect to the DC bus.

Optionally, the new energy subsystem includes a wind power generation system, a photovoltaic power generation system, an energy storage container power generation system, multiple DC/DC converters, and multiple DC distribution cabinets; the wind power generation system, the photovoltaic power generation system, and the energy storage container power generation system are respectively connected to the DC bus through corresponding DC/DC converters and corresponding DC distribution cabinets.

Optionally, the testing subsystem further includes a third DC power switch and a DC load, and the DC load is connected to the DC bus through the third DC power switch.

Optionally, the system further includes a centralized cooling subsystem configured to regulate temperatures of the DC bus subsystem, the new energy subsystem, and the testing subsystem.

Optionally, the centralized cooling subsystem includes an air energy generator, a first cooling control submodule, a second cooling control submodule, a third cooling control submodule, a fourth cooling control submodule, heat pipes, and cold pipes. The testing subsystem further includes a high temperature static cabinet and a normal/constant temperature static cabinet. The multiple energy storage inverters of the DC bus subsystem are connected to the first cooling control submodule through the heat pipes and the cold pipes, and the first cooling control submodule is connected to the air energy generator through the heat pipes and the cold pipes; the multiple DC/DC converters and the energy storage container power generation system of the new energy subsystem are respectively connected to the second cooling control submodule through the heat pipes and the cold pipes, and the second cooling control submodule is connected to the air energy generator through heat pipes and cold pipes; the multiple formation cabinets and multiple capacity-grading cabinets of the testing subsystem are respectively connected to the third cooling control submodule through the heat pipes and the cold pipes, and the third cooling control submodule is connected to the fourth cooling control submodule through the heat pipes and the cold pipes; the high temperature static cabinet and the normal/constant temperature static cabinet are respectively connected to the fourth cooling control submodule through the heat pipes and the cold pipes, and the fourth cooling control submodule is connected to the air energy generator through the heat pipes and the cold pipes; and the air energy generator is configured to convert heat into electricity through the heat pipes and deliver a coolant through the cold pipes.

Optionally, the system further includes an intelligent management subsystem which includes a communication network used for information transmission between the DC bus subsystem, the new energy subsystem, the testing subsystem, the centralized cooling subsystem, and the intelligent management subsystem.

Optionally, the intelligent management subsystem further includes an energy efficiency management module, and the energy efficiency management module is configured to collect data from the multiple AC distribution cabinets of the DC bus subsystem, the energy storage container power generation system and the multiple DC/DC converters of the new energy subsystem, and multiple DC/DC power supplies of the testing subsystem, and calculate the data, and control the system based on the data calculated and preset operating strategies.

Optionally, the intelligent management subsystem further includes a production logistics management module, and the production logistics management module is configured to collect operational data from the DC bus subsystem, the new energy subsystem, the testing subsystem, and the centralized cooling subsystem, and send operational instructions based on the data calculated from the energy efficiency management module, set the preset operating strategies, and send the operational data to the energy efficiency management module.

The original energy transfer path in the back section of the battery cell production requires not only DC/DC power supplies, but also AC/DC power supplies to achieve energy cycling between the discharging and charging battery cells. In the embodiment of the present invention, by using the DC bus to reduce the number of energy exchanges in the energy cycling process, the problem of low energy efficiency and large energy loss in the formation and capacity-grading charging and discharging process is avoided, which improves the energy utilization efficiency, reduces losses, and enhances the system energy efficiency, thereby solving the problem of energy waste in related technologies.

In the embodiments, various forms of new energy are converted into the DC power and then connected to the DC bus through the new energy subsystem, thereby achieving the effect of complementary control of multiple energy sources and improving the utilization of new energy and reducing the carbon emissions in the production testing process of battery cells.

In the embodiments, due to the centralized cooling subsystem, the traditional air cooling control strategy is changed to a water cooling control strategy, which achieves efficient transmission and control of heat energy, improves the power density of the power module, reduces the occupied area of the system, improves the operating efficiency of the system, and reduces the energy consumption of cooling, thereby reducing the carbon emissions and achieving the goal of a zero-carbon factory.

In the embodiments, by providing high-voltage DC power to the DC bus through the energy storage inverters, the system can reduce line losses, heat losses, and improve overall energy efficiency.

In the embodiments, multiple formation cabinets and capacity-grading cabinets are connected to the DC bus through the first DC power switch and the second DC power switch, respectively, to achieve microsecond-level fast response or disconnection. In the event of a short circuit or other faults, the electrical connection between the formation cabinets, the capacity-grading cabinets, and the DC bus can be quickly disconnected, thereby reducing the impact of system coupling. By providing high-voltage DC power to the DC bus through the energy storage inverters, the system can reduce line losses, heat losses, and improve overall energy efficiency.

In the embodiments, under the intelligent management subsystem, the collection, calculation, and control of data based on preset operating strategies can be achieved, which realizes intelligent integration, optimization, and energy saving effects for the system, thereby achieving centralized control, reducing independent operation of equipment, enabling proper scheduling, and improving system utilization.

### BRIEF DESCRIPTION OF THE DRAWINGS

The figures included in the specification form part of the disclosure and illustrate embodiments of the present invention, which are used together with the specification to explain the principles of the invention.

To provide a clearer description of the embodiments of the present invention or the technical solutions in the prior art, the accompanying drawings that are required in the description of the embodiments or the prior art will be briefly introduced. It is evident that persons ordinary skilled in the art may further obtain additional drawings based on these drawings without inventive contribution.
FIG. 1 is a schematic diagram of an energy-saving testing system for a microgrid DC bus in a back section of a battery cell production according to an embodiment of the present invention.
FIG. 2 is a schematic diagram of an energy-saving testing system for a microgrid DC bus in a back section of a battery cell production according to another embodiment of the present invention.
FIG. 3 is a schematic diagram showing a connection of a new energy subsystem according to an embodiment of the present invention.
FIG. 4 is a schematic diagram showing a connection of a centralized heat dissipation subsystem according to an embodiment of the present invention.
FIG. 5 is a schematic diagram of a communication network of an intelligent management subsystem according to an embodiment of the present invention.
FIG. 6 is an overall schematic diagram of an energy-saving testing system for a microgrid DC bus in a back section of a battery cell production according to an embodiment of the present invention.

### DETAILED DESCRIPTION OF ILLUSTRATED EMBODIMENTS

To enable those skilled in the art to better understand the present invention, the technical solutions in the embodiments of the present invention will be described clearly and completely in conjunction with the accompanying drawings in the embodiments of the present invention. It is apparent that the described embodiments are merely a part of the embodiments of the present invention, rather than all the embodiments. All other embodiments obtained by persons ordinarily skilled in the art without inventive contribution based on the embodiments in the present invention should also fall within the scope of protection of the present invention.

It should be noted that, in the description of the present invention, the terms "first," "second," etc. are used to distinguish similar objects and are not necessarily used to describe a specific order or sequence. It should be understood that the data used in this way can be interchanged in appropriate circumstances so that the embodiments of the present invention described herein can be implemented in a sequence other than that shown or described herein. Furthermore, the terms "comprising" and "having" and any variations thereof are intended to cover non-exclusive inclusions, such as a process, method, system, product, or apparatus that comprises a series of steps or units does not necessarily include only those steps or units explicitly listed, but may include other steps or units inherent to such process, method, system, product, or apparatus.

The terms "center", "up", "down", "left", "right", "vertical", "horizontal", "inner", "outer", and the like indicating positional relationships or orientations are based on the orientation or positional relationships shown in the drawings for the purpose of describing the present invention and simplifying the description. They should not be interpreted as limitations to the devices or components to specific orientations, constructions, and operations, which should not be understood as limiting the present invention therefore. The terms "installation", "connection" and "coupling" should be broadly interpreted. For example, the related elements may be in fixed connections or detachable connections, in mechanical connections or electrical connections, in direct connections or indirect connections through intermediate media, or in internal connections within two elements, in wireless connections or wired connections. Persons ordinarily skilled in the art can understand the specific meanings of these terms in the context of the present invention.

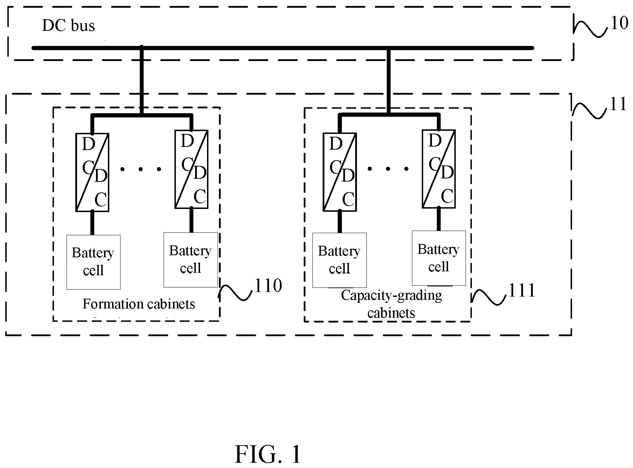

According to one aspect of the embodiments of the present invention, an energy-saving testing system for a microgrid DC bus in a back section of a battery cell production is provided. FIG. 1 is a schematic diagram of an energy-saving testing system for a microgrid DC bus in a back section of a battery cell production according to the embodiment of the present invention. As shown, the system includes a DC bus subsystem and a testing subsystem for the battery cell production in the back section. The DC bus subsystem includes a DC bus which provides a DC power to the testing subsystem; the testing subsystem includes multiple formation cabinets and multiple capacity-grading cabinets, each formation cabinet or each capacity-grading cabinet comprises a corresponding DC/DC power supply and a battery cell, and both the multiple formation cabinets and multiple capacity-grading cabinets are connected to the DC bus.

Optionally, as shown in FIG. 1, the multiple formation cabinets 110 and multiple capacity-grading cabinets 111 of the testing subsystem 11 are powered by the DC bus in the DC bus subsystem 10. The electrical energy of the DC bus may be provided by a power grid or distributed power sources, etc. It can be understood that a formation and capacity-grading production line includes multiple formation cabinets and multiple capacity-grading cabinets, and each formation cabinet and each capacity-grading cabinet is provided with multiple testing positions. During the formation and capacity-grading testing process, the battery cells are charged and discharged. In a traditional microgrid system, each testing position requires 2-4 low-power AC/DC power supplies, and the charging and discharging between different testing positions must pass through the AC circuit for energy cycling. In this embodiment, a different energy cycling path for charging and discharging the battery cells between different testing positions is achieved, such as discharging battery cell → DC/DC power supply → DC bus → DC/DC power supply → charging battery cell. By reducing the energy transfer path, the energy conversion efficiency is improved.

The original energy transfer path in the back section of the battery cell production requires not only DC/DC power supplies, but also AC/DC power supplies to achieve energy cycling between the discharging and charging battery cells. In the embodiment of the present invention, by using the DC bus to reduce the number of energy exchanges in the energy cycling process, the problem of low energy efficiency and large energy loss in the formation and capacity-grading charging and discharging process is avoided, which improves the energy utilization efficiency, reduces losses, and enhances the system energy efficiency, thereby solving the problem of energy waste in related technologies.

As an optional embodiment, the DC bus subsystem further includes multiple AC distribution cabinets, multiple energy storage inverters, a first DC distribution cabinet, a first DC power switch, and a second DC power switch. Each AC distribution cabinet is connected to a corresponding energy storage inverter, and the multiple energy storage inverters are connected to one end of the first DC distribution cabinet, another end of the first DC distribution cabinet is connected to the DC bus. One end of the first DC power switch is connected to the DC bus, and another end of the first DC power switch is connected to the multiple formation cabinets. One end of the second DC power switch is connected to the DC bus, and another end of the second DC power switch is connected to the multiple capacity-grading cabinets. Each AC distribution cabinet is configured to deliver a grid AC power to the corresponding energy storage inverter, which converts the grid AC power into the DC power. The first DC distribution cabinet is configured to combine DC powers from multiple energy storage inverters and deliver to the DC bus. The first DC power switch and the second DC power switch are configured to control a connection or a disconnection of the multiple formation cabinets and multiple capacity-grading cabinets to the DC bus.

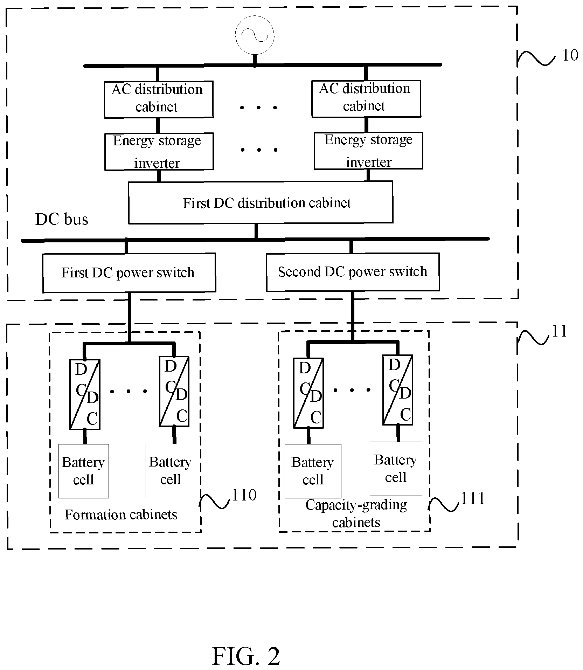

Optionally, as shown in FIG. 2, the multiple AC distribution cabinets of the DC bus subsystem 10 is configured to deliver the AC power of the grid to the corresponding energy storage inverters (PCS, Power Conversion System) to convert the AC power into a DC power. The converted DC powers from multiple energy storage inverters are collected by the first DC distribution cabinet and delivered to the DC bus, with the DC bus having an operate voltage up to 650V~1500V. The DC bus is connected to multiple formation cabinets and capacity-grading cabinets through the first DC power switch and the second DC power switch, respectively. The DC/DC power supplies inside the formation cabinets or capacity-grading cabinets convert the high voltage to below 5V for charging and discharging the battery cells. For example, the DC/DC power supply in the formation cabinet can be connected in series or parallel. Assuming there are 12 battery cells in series, the output voltage range of the series-connected DC/DC power supply is 0V~60V, and the output voltage range of the parallel-connected DC/DC power supply is 0V~5V. Since the voltage of a lithium battery cell is generally less than 5V, the converted voltage from the DC/DC power supply meets the testing standards. It should be noted that the energy storage inverters can also be used to control the stability of the DC bus. Specifically, the energy storage inverters operate in a constant voltage mode to stabilize the DC bus, with a voltage regulation accuracy of less than 1%. When there is sufficient energy on the DC bus, the energy storage inverters operate in an inversion mode, extracting energy from the DC bus to feed back to the grid for gains. When there is insufficient energy on the DC bus, the energy storage inverters operate in a rectification mode, extracting energy from the grid to power the system and maintain stable operation. Moreover, the energy storage inverters can also convert excess energy on the DC bus into AC power for the AC bus or improve the quality of the power grid for the DC bus and the AC bus.

In the embodiment, multiple formation cabinets and capacity-grading cabinets are connected to the DC bus through the first DC power switch and the second DC power switch, respectively, to achieve microsecond-level fast response or disconnection. In the event of a short circuit or other faults, the electrical connection between the formation cabinets, the capacity-grading cabinets, and the DC bus can be quickly disconnected, thereby reducing the impact of system coupling. By providing high-voltage DC power to the DC bus through the energy storage inverters, the system can reduce line losses, heat losses, and improve overall energy efficiency.

As an optional embodiment, the system further includes a new energy subsystem, which is connected to the DC bus and configured to converts various forms of new energy into the DC power before connecting to the DC bus. The new energy, also known as unconventional energy, refers to various forms of energy other than traditional energy sources, such as solar energy, geothermal energy, wind energy, ocean energy, or biomass energy, etc. By using the new energy subsystem to provide power to the DC bus, the system can effectively supplement the energy supply and reduce the carbon emissions. In this embodiment, various forms of new energy are converted into the DC power and then connected to the DC bus through the new energy subsystem, thereby achieving the effect of complementary control of multiple energy sources and improving the utilization of new energy and reducing the carbon emissions in the production testing process of battery cells.

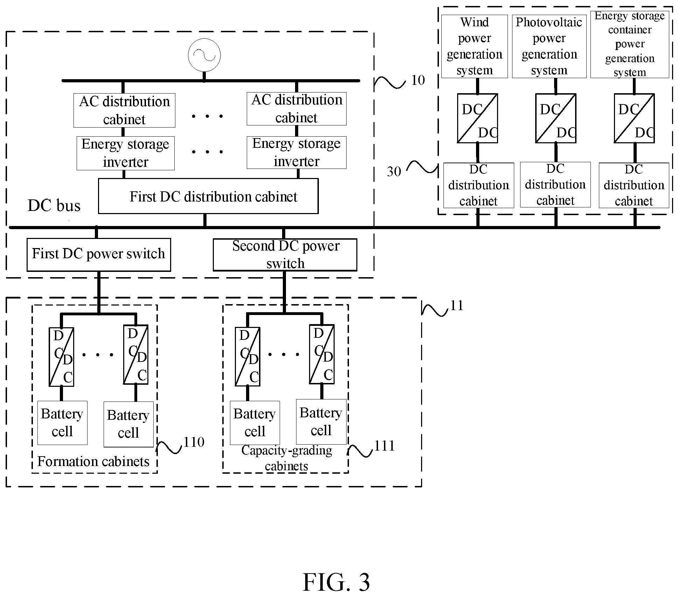

As another embodiment, the new energy subsystem includes a wind power generation system, a photovoltaic power generation system, an energy storage container power generation system, multiple DC/DC converters, and multiple DC distribution cabinets. The wind power generation system, the photovoltaic power generation system, and the energy storage container power generation system are respectively connected to the DC bus through corresponding DC/DC converters and corresponding DC distribution cabinets. Optionally, as shown in FIG. 3, the wind power generation system in the new energy subsystem 30 is configured to convert wind energy into electrical energy, which is then connected to the DC bus through the corresponding DC/DC converter and DC distribution cabinet, for providing stable zero-carbon electrical energy to the DC bus. The photovoltaic power generation system is configured to convert solar energy into electrical energy, which is then connected to the DC bus through the corresponding DC/DC converter and DC distribution cabinet, for providing stable zero-carbon electrical energy to the DC bus. The energy storage container power generation system is connected to the DC bus through the corresponding DC/DC converter and DC distribution cabinet, for storing excess electrical energy in the DC bus or sending the stored electrical energy to the DC bus, thereby achieving peak shaving in electricity consumption.

As an optional embodiment, the testing subsystem further includes a third DC power switch and a DC load, and the DC load is connected to the DC bus through the third DC power switch. Optionally, the DC load refers to a DC power load in the factory area, which is connected to the DC bus through the third DC power switch to directly obtain energy from the DC bus, thereby reducing the cost of electricity consumption in the factory area. The third DC power switch can achieve a microsecond-level fast response or a disconnection. In the event of a short circuit or other faults, a fast disconnection between the DC load and the DC bus may be ensured, thereby reducing the impact of system coupling.

As an optional embodiment, the system further includes a centralized cooling subsystem configured to regulate temperatures of the DC bus subsystem, the new energy subsystem, and the testing subsystem. Optionally, during the operation of the system, the energy storage inverter, the DC/DC power supply, the battery cells, the DC/DC converters, etc., generate heat and therefore the centralized cooling subsystem is necessary to regulate the temperature of each component.

As an optional implementation, the centralized cooling subsystem includes an air energy generator, a first cooling control submodule, a second cooling control submodule, a third cooling control submodule, a fourth cooling control submodule, heat pipes, and cold pipes. The testing subsystem further includes a high temperature static cabinet and a normal/constant temperature static cabinet. The multiple energy storage inverters of the DC bus subsystem are connected to the first cooling control submodule through the heat pipes and the cold pipes, and the first cooling control submodule is connected to the air energy generator through the heat pipes and the cold pipes. The multiple DC/DC converters and the energy storage container power generation system of the new energy subsystem are respectively connected to the second cooling control submodule through the heat pipes and the cold pipes, and the second cooling control submodule is connected to the air energy generator through heat pipes and cold pipes. The multiple formation cabinets and multiple capacity-grading cabinets of the testing subsystem are respectively connected to the third cooling control submodule through the heat pipes and the cold pipes, and the third cooling control submodule is connected to the fourth cooling control submodule through the heat pipes and the cold pipes. The high temperature static cabinet and the normal/constant temperature static cabinet are respectively connected to the fourth cooling control submodule through the heat pipes and the cold pipes, and the fourth cooling control submodule is connected to the air energy generator through the heat pipes and the cold pipes. The air energy generator is configured to convert heat into electricity through the heat pipes and deliver a coolant through the cold pipes.

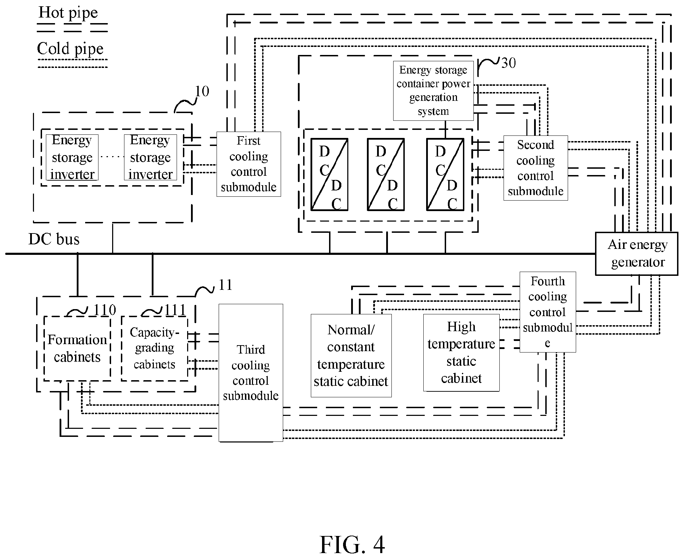

Optionally, as shown in FIG. 4, the first cooling control submodule is configured to control the temperature of multiple energy storage inverters in the DC bus subsystem 10 by using the cold pipes and the heat pipes. The second cooling control submodule is configured to control the temperature of multiple DC/DC converters and the energy storage container power generation system in the new energy subsystem 30 by using the cold pipes and the heat pipes. The third cooling control submodule is configured to control the temperature of multiple formation cabinets 110 and multiple capacity-grading cabinets 111 in the testing subsystem by using the cold pipes and the heat pipes. The fourth cooling control submodule is configured to control the temperature of the high temperature static cabinet and the normal/constant temperature static cabinet by using the cold pipes and the heat pipes. Specifically, the parts that require temperature control, such as the high temperature static cabinet and the normal/constant temperature static cabinet, may be matched with the corresponding temperature preset value based on the corresponding environmental temperature detection table. The fourth cooling control submodule is configured to control a flow rate and a flow of the coolant in the cold pipes based on the difference between a measured value of the current environmental temperature and the temperature preset value, thereby achieving real-time dynamic temperature adjustment and maintaining the environmental temperature at the preset value. In addition, the air energy generator may convert excess heat energy into electricity through the corresponding DC/DC converters and corresponding DC distribution cabinets, and deliver the electricity to the DC bus for various loads.

In the embodiment, due to the centralized cooling subsystem, the traditional air cooling control strategy is changed to a water cooling control strategy, which achieves efficient transmission and control of heat energy, improves the power density of the power module, reduces the occupied area of the system, improves the operating efficiency of the system, and reduces the energy consumption of cooling, thereby reducing the carbon emissions and achieving the goal of a zero-carbon factory.

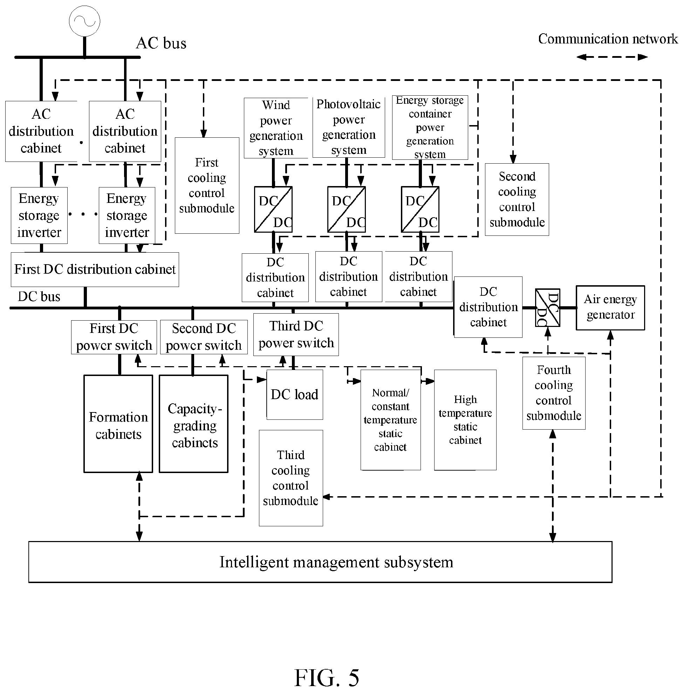

As an optional implementation, the system further includes an intelligent management subsystem, which includes a communication network used for information transmission between the DC bus subsystem, the new energy subsystem, the testing subsystem, the centralized cooling subsystem, and the intelligent management subsystem. Optionally, as shown in FIG. 5, the multiple AC distribution cabinets, the multiple energy storage inverters, the first DC distribution cabinet, and the multiple cooling control submodules are all connected to the communication network, allowing data transmission between the modules and devices within the system.

As an optional embodiment, the intelligent management subsystem further includes an energy efficiency management module. The energy efficiency management module is configured to collect data from the multiple AC distribution cabinets of the DC bus subsystem, the energy storage container power generation system and the multiple DC/DC converters of the new energy subsystem, and the multiple DC/DC power supplies of the testing subsystem, and calculate the data, and control the system based on the data calculated and preset operating strategies. Optionally, the energy efficiency management module is configured to collect data from equipment such as the energy storage inverters, the energy storage container power generation systems, and the DC/DC converters, and control the stable operation of the DC bus based on preset operating strategies. Specifically, the preset operating strategies may follow. When both the wind power generation system and the photovoltaic power generation system generate power or when there is excessive energy on the DC bus, the energy efficiency management module controls the operation of the energy storage container power generation system to store excess energy. When it is nighttime or when the energy feedback on the DC bus decreases, the energy efficiency management module controls the operation of the energy storage container power generation system to release energy. The energy storage inverter may control the stability of the DC bus and also convert the excess energy on the DC bus to the AC bus or improve the quality of the power grids for the DC bus and the AC bus. The system temperature is controlled by the heat dissipation control subsystem based on the collected data, which ensures that each power module operates at an optimal temperature. Furthermore, the excess heat energy may be converted into electrical energy through the air energy generator, thereby improving the system's operating efficiency.

As an optional implementation, the intelligent management subsystem further includes a production logistics management module, and the production logistics management module is configured to collect operational data from the DC bus subsystem, the new energy subsystem, the testing subsystem, and the centralized cooling subsystem, and send operational instructions based on the data calculated from the energy efficiency management module, set preset operating strategies, and send the operational data to the energy efficiency management module. Optionally, the production logistics management module is configured to collect operational data from various subsystems and issue the operational instructions to the multiple formation cabinets, the multiple formation cabinets, the first DC power switch, the DC load, the high temperature static cabinet, and the normal/constant temperature static cabinet. Under intelligent configuration of the operation and control strategies, simultaneous charging and discharging of the formation cabinets and capacity-grading cabinets may be controlled, which aims to extract as much energy as possible from the DC bus. This means that energy circulation is achieved between the charging and discharging of the formation cabinets and the charging and discharging of the capacity-grating cabinets, thereby reducing the power consumption of the factory area and optimizing the operating efficiency of the system.

The production logistics management module may also exchange data with the energy efficiency management module. The production logistics management module is further configured to transfer the collected data from the multiple formation cabinets, the multiple formation cabinets, the first DC power switch, the DC load, the high temperature static cabinet, and the normal/constant temperature static cabinet to the energy efficiency management module. The energy efficiency management module is configured to transfer the electrical energy and the efficiency of the DC bus subsystem, and the system temperature to the production logistics management module. Finally, the production logistics management module uses intelligent algorithms to control the operation of various modules of the battery cell production testing system according to the optimal process strategy. Specifically, the energy efficiency management module is configured to obtain the power data required for the current batter cell testing from the production logistics management module, and intelligently predict the power generation and load consumption at each port in combination with the current power status and historical data of the energy storage power generation system, the photovoltaic power generation system, and the wind power generation system, and finally optimally manage the efficiency of each module based on the prediction results.

In the embodiment, under the intelligent management subsystem, the collection, calculation, and control of data based on preset operating strategies can be achieved, which realizes intelligent integration, optimization, and energy saving effects for the system, thereby achieving centralized control, reducing independent operation of equipment, enabling proper scheduling, and improving system utilization.

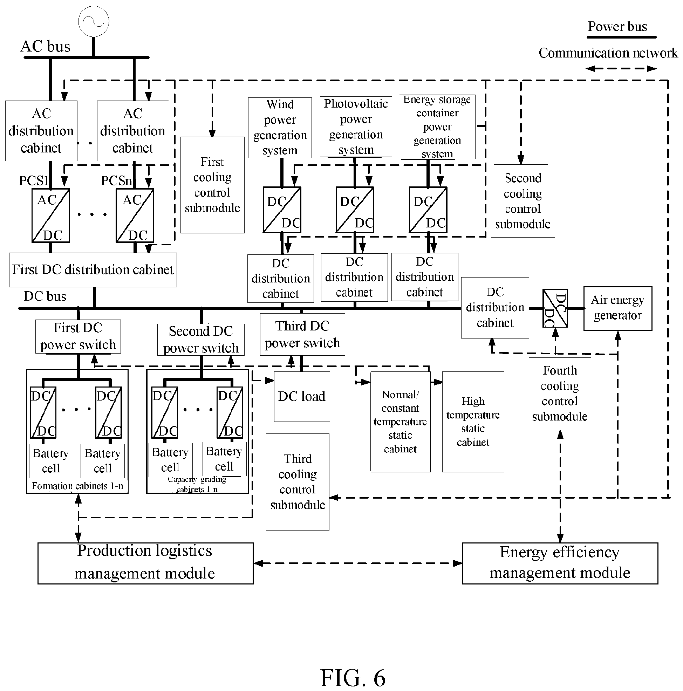

As an optional implementation, FIG. 6 is an overall schematic diagram of an energy-saving testing system for a microgrid DC bus in a back section of a battery cell production according to an embodiment of the present invention. As shown, the main grid passes through the AC bus and connects to PCS1~PCSn through the multiple AC distribution cabinets, and then the AC power is converted into DC power and input to the DC bus through the first DC distribution cabinet. The operate voltage of the DC bus is in a high voltage range of 650V to 1500V. The DC bus is connected to the general distribution interface of the formation cabinets 1 to n through the first DC power switch, and connected to the general distribution interface of the capacity-grading cabinets 1 to n through the second DC power switch, then, the DC/DC power supply in the formation cabinet converts the high voltage to less than 5V to supply charging and discharging for the battery cells. In the DC bus subsystem, various new energy power generation systems such as the air energy generators, the energy storage container power generation systems, the photovoltaic power generation systems, and the wind power generation systems are connected to provide renewable energy to the DC bus. The heat generated during the operation of PCS, the DC/DC power supply in the formation cabinets, the battery cells, the DC/DC power supply in the capacity-grading cabinets, the energy storage container, and the DC/DC converter is transported to the high temperature static cabinet and the normal/constant temperature static cabinet through the air energy generator and the heat dissipation control submodule, thereby reducing heat energy loss. The air energy generator may convert the excess heat energy into electrical energy and connect to the DC bus for various loads.

The battery cells are processed in the front section and middle section to become uncharged battery cells, which are then placed in the high temperature static cabinets. Then the uncharged battery cells are sent to the formation cabinets 1 to n to complete the formation process, and then charged and discharged by the DC power supply in the formation cabinet to complete the activation process, and then placed in the normal/constant temperature static cabinets. Then the battery cells are sent to the capacity-grading cabinets 1 to n to complete the capacity-grading process, and then charged and discharged by the DC power supply in the capacity-grading cabinets to complete the capacity-grading process, and finally placed in the normal/constant temperature static cabinets. The heat dissipation control submodule is configured to control the air energy generator to convert the heat generated during the operation of PCS, the DC/DC power supply in the formation cabinets, the battery cells, the DC/DC power supply in the capacity-grading cabinets, the energy storage container power generation system, and the DC/DC converter into electrical energy, and further control the cold pipes to transport the coolant to the high temperature static cabinets and the normal/constant temperature static cabinets for heat dissipation, thereby reducing heat energy loss. The air energy generator is configured to convert excess heat energy into electrical energy and connects it to the DC bus for various loads. The system can achieve data transmission within the system through the communication network and set preset strategies based on collected data through the production logistics management module and the energy efficiency management module, thereby achieving overall scheduling of the system and saving energy.

The beneficial effects of the embodiments follow. The power supply for charging and discharging the battery cells in the back section is changed from a distributed system to a centralized microgrid DC bus system, namely, instead of the traditional four-stage energy conversion process (battery cell → DC/DC → DC/AC → AC/DC → DC/DC → battery cell), it is optimized to a two-stage energy conversion process (battery cell → DC/DC → DC/DC → battery cell), thereby reducing the number of energy exchanges and improving system efficiency. The energy-saving measures of the traditional formation and capacity-grading testing system is integrated to system-level energy saving and consumption reduction, so as to achieve intelligent data optimization, and improve the energy-saving effects. The cooling method of the system is optimized from air cooling to water cooling, thereby improving overall energy efficiency utilization, and also reducing the energy consumption and the carbon emissions associated with the high temperature static cabinet, etc. Energy scheduling and centralized temperature control between different modules are achieved, which reduces the need for independent operating equipment and enabling the rational allocation of energy and temperature. Furthermore, multi-energy complementary control strategies are applied, for example interfaces for the integrating photovoltaic, the wind power, and the energy storage systems are added, thereby improving the utilization of renewable energy and reducing the carbon emissions and the heat dissipation into the air.

The above description is only preferred embodiments of the present invention. It should be pointed out that those skilled in the art can make various improvements and modifications without departing from the principles of the present invention, and these improvements and modifications should also be regarded as within the scope of the present invention.

## Claims

1. An energy-saving testing system for a microgrid DC bus in a back section of a battery cell production, comprising a DC bus subsystem and a testing subsystem for the battery cell production in the back section,
wherein the DC bus subsystem comprises a DC bus configured to provide a DC power to the testing subsystem; the testing subsystem comprises multiple formation cabinets and multiple capacity-grading cabinets, each formation cabinet or each capacity-grading cabinet comprises a corresponding DC/DC power supply and a battery cell, and the multiple formation cabinets and multiple capacity-grading cabinets are connected to the DC bus.

2. The system according to claim 1, wherein the DC bus subsystem further comprises multiple AC distribution cabinets, multiple energy storage inverters, a first DC distribution cabinet, a first DC power switch, and a second DC power switch;
each AC distribution cabinet is connected to a corresponding energy storage inverter, and the multiple energy storage inverters are connected to one end of the first DC distribution cabinet, another end of the first DC distribution cabinet is connected to the DC bus; one end of the first DC power switch is connected to the DC bus, and another end of the first DC power switch is connected to the multiple formation cabinets; one end of the second DC power switch is connected to the DC bus, and another end of the second DC power switch is connected to the multiple capacity-grading cabinets;
each AC distribution cabinet is configured to deliver a grid AC power to the corresponding energy storage inverter, which converts the grid AC power into the DC power; the first DC distribution cabinet is configured to combine DC powers from multiple energy storage inverters and deliver to the DC bus; and the first DC power switch and the second DC power switch are configured to control a connection or a disconnection of the multiple formation cabinets and multiple capacity-grading cabinets to the DC bus.

3. The system according to claim 2, further comprising a new energy subsystem connected to the DC bus and configured to convert various new energy sources into the DC power and then connect to the DC bus.

4. The system according to claim 3, wherein the new energy subsystem comprises a wind power generation system, a photovoltaic power generation system, an energy storage container power generation system, multiple DC/DC converters, and multiple DC distribution cabinets; the wind power generation system, the photovoltaic power generation system, and the energy storage container power generation system are respectively connected to the DC bus through corresponding DC/DC converters and corresponding DC distribution cabinets.

5. The system according to claim 4, wherein the testing subsystem further comprises a third DC power switch and a DC load, and the DC load is connected to the DC bus through the third DC power switch.

6. The system according to claim 5, further comprising a centralized cooling subsystem configured to regulate temperatures of the DC bus subsystem, the new energy subsystem, and the testing subsystem.

7. The system according to claim 6, wherein the centralized cooling subsystem comprises an air energy generator, a first cooling control submodule, a second cooling control submodule, a third cooling control submodule, a fourth cooling control submodule, heat pipes, and cold pipes; the testing subsystem further comprises a high temperature static cabinet and a normal/constant temperature static cabinet;
the multiple energy storage inverters of the DC bus subsystem are connected to the first cooling control submodule through the heat pipes and the cold pipes, and the first cooling control submodule is connected to the air energy generator through the heat pipes and the cold pipes; the multiple DC/DC converters and the energy storage container power generation system of the new energy subsystem are respectively connected to the second cooling control submodule through the heat pipes and the cold pipes, and the second cooling control submodule is connected to the air energy generator through heat pipes and cold pipes; the multiple formation cabinets and multiple capacity-grading cabinets of the testing subsystem are respectively connected to the third cooling control submodule through the heat pipes and the cold pipes, and the third cooling control submodule is connected to the fourth cooling control submodule through the heat pipes and the cold pipes; the high temperature static cabinet and the normal/constant temperature static cabinet are respectively connected to the fourth cooling control submodule through the heat pipes and the cold pipes, and the fourth cooling control submodule is connected to the air energy generator through the heat pipes and the cold pipes; and the air energy generator is configured to convert heat into electricity through the heat pipes and deliver a coolant through the cold pipes.

8. The system according to claim 7, further comprising an intelligent management subsystem which comprises a communication network used for information transmission between the DC bus subsystem, the new energy subsystem, the testing subsystem, the centralized cooling subsystem, and the intelligent management subsystem.

9. The system according to claim 8, wherein the intelligent management subsystem further comprises an energy efficiency management module, and the energy efficiency management module is configured to collect data from the multiple AC distribution cabinets of the DC bus subsystem, the energy storage container power generation system and the multiple DC/DC converters of the new energy subsystem, and multiple DC/DC power supplies of the testing subsystem, and calculate the data, and control the system based on the data calculated and preset operating strategies.

10. The system according to claim 9, wherein the intelligent management subsystem further comprises a production logistics management module, and the production logistics management module is configured to collect operational data from the DC bus subsystem, the new energy subsystem, the testing subsystem, and the centralized cooling subsystem, and send operational instructions based on the data calculated from the energy efficiency management module, set the preset operating strategies, and send the operational data to the energy efficiency management module.
